Europäisches Patentamt

European Patent Office

Office européen des brevets

(11) Veröffentlichungsnummer: **0 276 510 B1**

(12) **EUROPÄISCHE PATENTSCHRIFT**

(45) Veröffentlichungstag der Patentschrift: **26.06.91**

(21) Anmeldenummer: **87202521.8**

(22) Anmeldetag: **15.12.87**

(51) Int. Cl.⁵: **G01R 33/36**

(54) **Kernresonanzgerät mit verstimmter Hf-Spule.**

(30) Priorität: **22.12.86 NL 8603252**

(43) Veröffentlichungstag der Anmeldung:
**03.08.88 Patentblatt 88/31**

(45) Bekanntmachung des Hinweises auf die
Patenterteilung:
**26.06.91 Patentblatt 91/26**

(84) Benannte Vertragsstaaten:
**BE DE FR GB IT SE**

(56) Entgegenhaltungen:
**EP-A- 0 151 745      EP-A- 0 164 164
EP-A- 0 175 129      DE-A- 3 427 666
GB-A- 2 050 062      GB-A- 2 153 086**

(73) Patentinhaber: **N.V. Philips' Gloeilampenfabrieken
Groenewoudseweg 1
NL-5621 BA Eindhoven(NL)**

(72) Erfinder: **Van Heelsbergen, Teunis Robert
c/o INT. OCTROOIBUREAU B.V. Prof. Holstlaan 6
NL-5656 AA Eindhoven(NL)**

(74) Vertreter: **Faessen, Louis Marie Hubertus et al
INTERNATIONAAL OCTROOIBUREAU B.V. 6
Prof. Holstlaan
NL-5656 AA Eindhoven(NL)**

Rank Xerox (UK) Business Services

## Beschreibung

Die Erfindung betrifft ein Kernresonanzgerät mit einer im wesentlichen zylinderförmigen Hf-Spule, in der mit einer Anzahl axial über einen Zylindermantel verlaufender Stableiter und einer Anzahl damit zusammenarbeitender Kapazitäten eine im wesentlichen kosinusförmige Stromverteilung auf einen kreiszylindrischen Umfang erzeugbar ist. Eine Hf-Spule für ein derartiges Kernresonanzgerät ist aus der US-PS 4 339 718 bekannt und basiert auf der schon lange bekannten Erkenntnis, dass für eine homogene Feldverteilung in einer derartigen Spule eine kosinusförmige Stromverteilung auf den Umfang der zylinderförmigen Spule erforderlich ist. Derartige Spulen werden auch mit Käfigspulen bezeichnet und sind in derartigen Kernresonanzgeräten in mehreren Ausführungen verfügbar.

In einem Ausführungsbeispiel dient die Käfigspule zum Erzeugen und Detektieren eines Hf-Feldes zum Erzeugen und Messen magnetischer Resonanzsignale in einem Körperteil eines Patienten. Nunmehr wird eine derartige Käfigspule oft zusammen mit einer weiteren Spule, beispielsweise einer Oberflächenspule, verwendet, wobei die Käfigspule zum Erzeugen eines Hf-Feldes und die Oberflächenspule zum Detektieren der mit dem Hf-Feld erzeugten Kernresonanzsignale verwendet werden. Da die Frequenz des Hf-Feldes und der Kernresonanzsignale gleich ist, stört die Oberflächenspule die Käfigspule beim Erzeugen des Hf-Feldes und die Käfigspule stört die Oberflächenspule beim Detektieren der Kernresonanzsignale.

Es ist daher notwendig, dass eine Spule verstimmt oder abgeschaltet wird, wenn die andere aktiv ist und umgekehrt, um eine gegenseitige unerwünschte Beeinflussung zu vermeiden. Es ist nun bekannt, dass Verstimmung eines Resonanzkreises durch Kurzschluss einer Kapazität erreicht wird. Dieser Grundsatz könnte auch in der Käfigspule ausgenutzt werden. Eine derartige Spule besteht jedoch aus einer Reihenschaltung von Spulen und Kapazitäten. Das Kurzschliessen einer Kapazität an nur einer Stelle verstimmt die Käfigspule nur so gering, dass hiermit eine umzureichende Entkopplung der Oberflächenspule bewirkt wird. Eine auf der Hand liegende Lösung dieses Problems könnte das Kurzschliessen der Kapazitäten an vielen Stellen sein. Diese Lösung ist jedoch technisch verhältnismässig kompliziert und beeinträchtigt weiter die Qualität der Spule, was unerwünscht ist.

Der Erfindung liegt die Aufgabe zugrunde, ein Kernresonanzgerät zu schaffen, das mit einer auf einfache Weise verstimmbaren Käfigspule ausgerüstet ist.

Zur Lösung dieser Aufgabe ist ein Kernresonanzgerät nach der Erfindung dadurch gekennzeichnet, dass eine Kapazität der Spule zum Verstimmen der Resonanzfrequenz der Hf-Spule mit einem induktiven Element überbrückbar ist, wobei das induktive Element eine für Hochfrequenzen geeignete Übertragungsleitung ist, wobei ein erster bzw. ein zweiter Leiter an einem Ende der Übertragungsleitung an eine Seite bzw. an die andere seite der Kapazität angeschlossen ist, und zwischen den beiden Leitern am anderen Ende über einen Schalter ein Kurzschluss gebildet werden kann. Beim bevorzugten Ausführungsbeispiel des erfindungsgemässen Geräts wird das induktive Element durch eine für Hochfrequenzen geeignete Übertragungsleitung, wie beispielsweise ein Koaxkabel, gebildet. Dabei werden der leitende Kern und der Mantel des Kabels an eine Seite bzw. an die andere Seite einer zu überbrückenden Kapazität angeschlossen. Dabei ist am anderen Ende der Übertragungsleitung ein Diodenbrückenschalter angeordnet, der den Kern mit dem Mantel verbinden kann. Bei dieser einfachen Verstimmungsweise der Käfigspule wird mit einem elektronisch bedienbaren Halbleiterschalter die Verstimmung ein- oder ausgeschaltet. Wichtig bei dieser Lösung ist, dass die Qualität dieser Hf-Spule nicht beeinträchtigt wird.

Ein weiteres Ausführungsbeispiel eines erfindungsgemässen Kernresonanzgeräts ist dadurch gekennzeichnet, dass die Hf-Energie über die Übertragungsleitung zugeleitet wird. Ausführungsbeispiele der Erfindung werden nachstehend an Hand der Zeichnung näher erläutert. Es zeigen

Fig. 1 ein erfindungsgemässes Kernresonanzgerät,

Fig. 2 ein Prinzipschaltbild einer erfindungsgemäss zu verstimmenden Hf-Spule,

Fig. 3 ein praktisches Ausführungsbeispiel einer erfindungsgemässen Hf-Spule, und

Fig. 4 ein weiteres Ausführungsbeispiel einer erfindungsgemässen Hf-Spule.

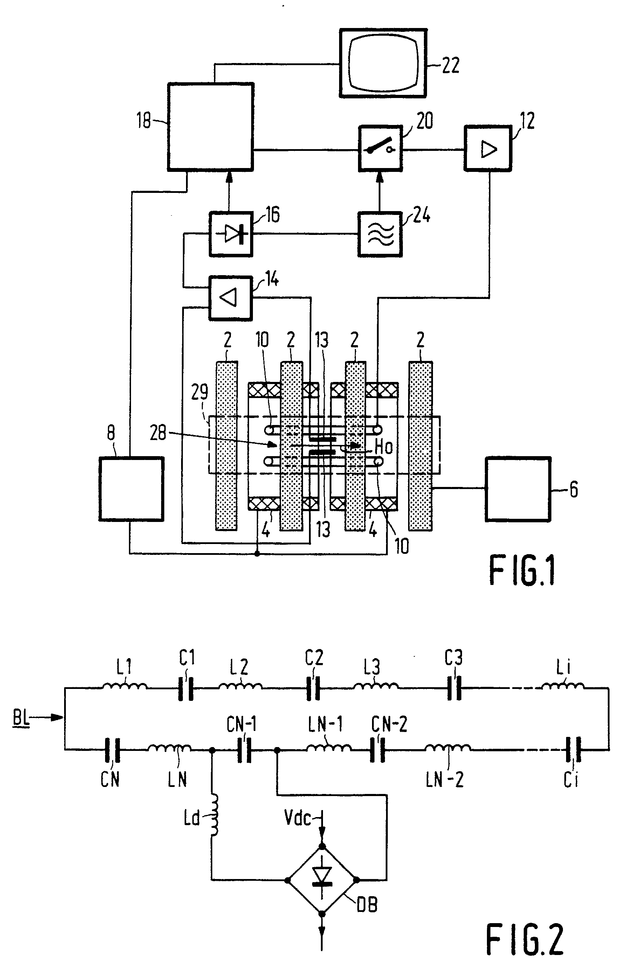

Ein Kernspinresonanzgerät nach Fig. 1 enthält ein Magnetsystem 2 zum Erzeugen eines statischen Magnetfelds HO, ein Magnetsystem 4 zum Erzeugen magnetischer Gradientenfelder und Speisequellen 6 und 8 für das Magnetsystem 2 bzw. das Magnetsystem 4. Eine Hf-Magnetspule 10 dient zum Erzeugen eines hochfrequenten Magnetwechselfeldes und ist dazu an eine Hf-Quelle 12 angeschlossen. Für die Detektierung des vom Hf-Sendefeld erzeugten Resonanzsignals in einem zu untersuchenden Objekt wird eine Hf-Empfangsspule 13 ausgenutzt (beispielsweise eine Oberflächenspule), und diese ist dazu mit einem Signalverstärker 14 verbunden. Der Signalverstärker 14 ist mit einem phasenempfindlichen Gleichrichter 16 verbunden, der an eine zentrale Steueranordnung 18 angeschlossen ist. Die zentrale Steueranordnung 18 steuert noch einen Modulator 20 für die Hf-Quelle 12, die Speisequelle 8 für die Gradientenspulen und einen Monitor 22 für die Bildwiedergabe. Ein Hochfrequenzoszillator 24 steuert sowohl den Modulator 20 als auch den Messignale verarbeitenden phasenempfindlichen Gleichrichter 16. Die in den Magnetsystemen 2 und 4 angeordnete Sendespule 10 schliesst einen Messraum 28 ein, der bei einem Gerät für medizinische diagnostische Messungen gross genug zum Aufnehmen eines zu untersuchenden Patienten ist. Im Messraum 28 können also ein statisches Magnetfeld HO, Objektschnitt wählende Gradientenfelder und ein räumlich homogenes Hf-Wechselfeld erzeugt werden. Die Hf-Spule 10 ist nach dem Erzeugen eines Hf-Magnetfeldes schnell abzuschalten, weil anschliessend das erzeugte Resonanzsignal mit der Empfangsspule 13 zu detektieren ist. Die Hf-Spule 10 muss dazu abgeschaltet werden, damit die Detektierung der Resonanzsignale mit der Empfangsspule 13 nicht gestört wird.

Um der vorangehenden Bedingung zu entsprechen, ist daher eine der Kapazitäten der Käfigspule mit einem induktiven Element überbrückt. Dieses induktive Element ist mit elektronischen Schaltmitteln ein- und ausschaltbar. In Fig. 2 ist das Prinzip einer Käfigspule BL nach der Erfindung dargestellt. Die Käfigspule ist grundsätzlich eine Reihenschaltung mit den Spulen L1... Li... LN und den Kapazitäten C1, ..., Ci, ... CN, wie schematisch in Fig. 2 dargestellt. Weiter ist in Fig. 2 die Überbrückung der Kapazität CN-1 mit einem induktiven Element Ld dargestellt, das mit einem Diodenschalter DB in Reihe geschaltet ist. Dieser Diodenschalter ist mit einer daran anzulegenden Spannung Vdc rasch ein- und ausschaltbar, so dass nach dem Erzeugen eines Hf-Magnetfeldes durch die in Fig. 2 dargestellte BL-Spule dieses Feld schnell ausschaltbar ist. Der in Fig. 2 dargestellte Halbleiterschalter DB kann ein Diodenbrückenschalter mit PIN-Dioden, aber auch eine Reihenschaltung aus einigen PIN-Halbleiterdioden sein.

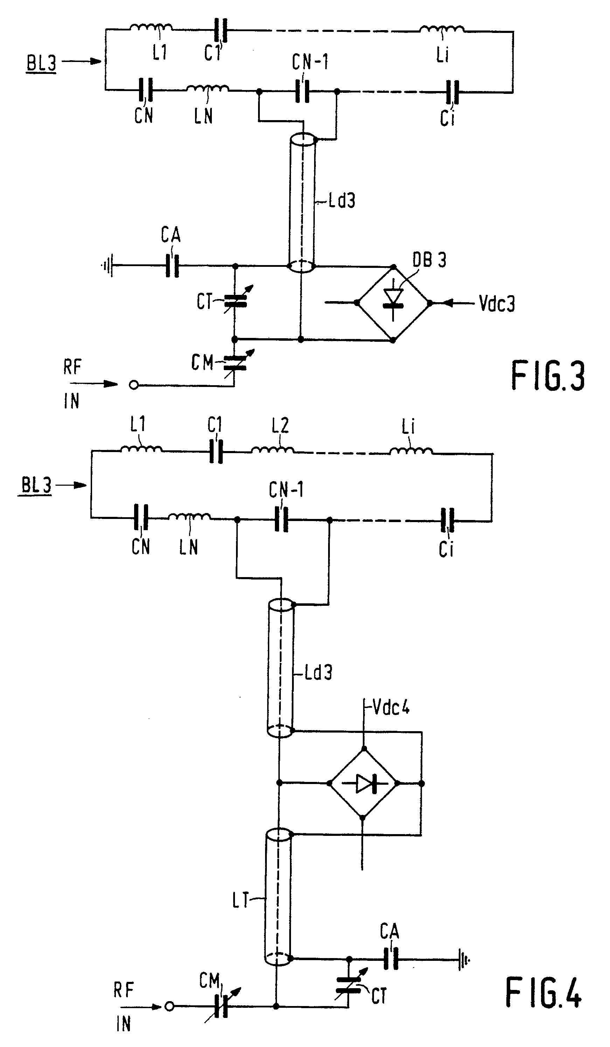

In Fig. 3 ist ein praktisches Ausführungsbeispiel der Käfigspule BL3 mit dem induktiven Element Ld3 und einer Schalter DB3 für ein erfindungsgemässes Kernresonanzgerät dargestellt. Entsprechend Fig. 3 ist die zu überbrückende Kapazität CN-1 einerseits an den Kern einer Hf-Übertragungsleitung Ld3 und die andere Seite der Kapazität CN-1 an ihren Mantel angeschlossen. Am anderen Ende der Übertragungsleitung Ld3 ist zwischen den Kern und den Mantel dieser Leitung eine Diodenbrückenschalter DB3 aufgenommen. Dieser Diodenbrückenschalter DB3 lässt sich durch das Zuführen einer geeigneten Spannung Vdc3 zwischen den beiden anderen Anschlusspunkten in den leitenden Zustand oder in den gesperrten Zustand bringen, was bedeutet, dass im ersten Fall die Übertragungsleitung die Kapazität CN-1 überbrückt und im anderen Fall als Zuleitung für Hochfrequenzleistung dient, die über eine Kapazität CM den Kern zugeführt wird. Weiter ist die Diodenbrücke DB3 zu einer Kapazität CT parallel geschaltet und der Mantel ist über eine weitere Kapazität CA mit Masse verbunden. Die Kapazität CT dient zum Abstimmen des Ganzen auf die gewünschte Resonanzfrequenz, wenn die Diodenbrückenschaltung DB3 nicht kurzgeschlossen ist. Die Hochfrequenzenergie wird über eine Kapazität CM zugeführt, die zum Anpassen der Impedanz der in Fig. 3 dargestellten Schaltung an die Ausgangsimpedanz des Hochfrequenzsenders 12 (Fig. 1) erforderlich ist, damit keine Reflexionen auftreten.

In Fig. 4 ist eine Abwandlung des praktischen Ausführungsbeispiels der Fig. 3 dargestellt. Die Bauteile in Fig. 4, deren Indentität hinsichtlich Verwendung und Aufgabe den Bauteilen in Fig. 3 gleich sind, führen die gleichen Bezugsziffern. In Fig. 4 ist jedoch die Diodenbrücke DB3 an eine weitere Übertragungsleitung LT angeschlossen, über die die Hochfrequenzenergie ankommt. Das Ende dieser Übertragungsleitung LT ist jetzt an den Abstimmkondensator CT angeschlossen, der den Kern des Koaxkabels LT mit seinem Mantel verbindet. Weiter ist der Mantel dieses Koaxkabels LT über eine Kapazität CA mit Masse verbunden und die Hochfrequenzenergie gelangt an den Kern des Koaxkabels LT über eine Anpassungskapazität CM, deren andere Seite den Eingang bildet.

## Ansprüche

1. Kernresonanzgerät mit einer im wesentlichen zylinderförmigen Hf-Spule (10,BL,BL3), in der mit einer Anzahl axial über einen Zylindermantel verlaufender Stableiter und einer Anzahl damit zusammenarbeitender Kapazitäten (C1, C2, ... CN) eine im wesentlichen kosinusförmige Stromverteilung auf einen kreiszylindrischen Umfang erzeugbar ist, und beider eine Kapazität (CN-1) der Spule (10, BL, BL3) mit einem induktiven Element (Ld, Ld3) zum Verstimmen der Resonanzfrequenz der Hf-Spule (10, BL, BL3) überbrückbar ist, wobei das induktive Element (Ld, Ld3) eine für Hochfrequenzen geeignete Übertragungsleitung ist, bei der ein erster bzw. zweiter Leiter der Übertragungsleitung an einem Ende der Übertragungsleitung an eine Seite bzw. an die andere Seite der Kapazität (CN-1) angeschlossen ist und zwischen den beiden Leitern am anderen Ende über einen Schalter (DB, DB3) ein Kurzschluss bildbar ist.

2. Kernresonanzgerät nach Anspruch 2, dadurch gekennzeichnet, dass die Übertragungsleitung (Ld, Ld3) ein Koaxkabel ist.

3. Kernresonanzgerät nach Anspruch 1, dadurch gekennzeichnet, dass der Schalter (DB, DB3) ein Diodenbrückenschalter ist.

4. Kernresonanzgerät nach Anspruch 3, dadurch gekennzeichnet, dass die Dioden in dem Diodenbrückenschalter PIN-Dioden sind.

5. Kernresonanzgerät nach Anspruch 1, dadurch gekennzeichnet, dass die Hf-Energie im eingeschalteten Zustand der Spule (10, BL, BL3) über die Übertragungsleitung (Ld, Ld3) zuleitbar ist.

## Claims

1. The invention relates to a magnetic resonance imaging apparatus, comprising a substantially cylindrical RF coil (10, BL, BL3) in which a substantially cosinusoidal current distribution can be generated across a circular-cylindrical circumference by means of a number of rod conductors, extending axially across a cylindrical surface, in cooperation with a number of capacitances (C1, C2, ... CN), it being possible to bridge a capacitance (CN-1) of the coil (10, Bl, Bl3) by means of an inductive element (Ld, Ld3) for detuning the resonant frequency of the RF coil (10, BL, BL3), the inductive element (Ld, Ld3) being formed by a transmission line which is suitable for radio frequencies, at one end of the transmission line a first and a second conductor of the transmission line being connected to the one side and the other side of the capacitance (CN-1), respectively, it being possible to form a short-circuit between the two conductors at the other end by means of a switch (DB, DB3).

2. A magnetic resonance imaging apparatus as claimed in Claim 1, characterized in that the transmission line (Ld, Ld3) is a coaxial cable.

3. A magnetic resonance imaging apparatus as claimed in Claim 1, characterized in that the switch (DB, DB3) is a diode bridge switch.

4. A magnetic resonance imaging apparatus as claimed in Claim 3, characterized in that the diodes of the diode bridge switch are PIN diodes.

5. A magnetic resonance imaging apparatus as claimed in Claim 1, characterized in that the RF energy can be applied via the transmission line (Ld, Ld3) in the activated condition of the coil (10, BL, Bl3).

## Revendications

1. Appareil de résonance magnétique nucléaire comportant une bobine Hf principalement de forme cylindrique (10, BL, BL3), dans lequel une répartition de courant principalement cosinusoïdale peut être obtenue sur une périphérie cylindrique circulaire à l'aide d'un certain nombre de barreaux conducteurs s'étendant axialement sur une enveloppe cylindrique et d'un certain nombre de condensateurs (C1, C2 ... CN) coopérant avec ceux-ci et dans lequel un condensateur (CN-1) de la bobine (10, BL, BL3) peut être ponté par un élément inductif (Ld, Ld3) pour désaccorder la fréquence de résonance de la bobine Hf (10, BL, BL3), l'élément inductif (Ld, Ld3) étant une ligne de transmission appropriée aux hautes fréquences, dont un premier et un second conducteur sont respectivement connectés, de part et d'autre du condensateur (CN-1), à l'une de ses extrémités, tandis qu'à l'autre extrémité, un court-circuit peut être établi entre les deux conducteurs par l'intermédiaire d'un commutateur (DB, DB3).

2. Appareil de résonance magnétique nucléaire suivant la revendication 1, caractérisé en ce que la ligne de transmission (Ld, Ld3) est un câble coaxial.

3. Appareil de résonance magnétique nucléaire suivant la revendication 1, caractérisé en ce que le commutateur (DB, DB3) est un commutateur à pont de diodes.

4. Appareil de résonance magnétique nucléaire suivant la revendication 3, caractérisé en ce que les diodes du commutateur à pont de diodes sont des diodes PIN.

5. Appareil de résonance magnétique nucléaire suivant la revendication 1, caractérisé en ce que, lorsque la bobine (10, BL, BL3) est enclenchée, l'énergie Hf peut être admise par la ligne de transmission (Ld, Ld3).

**FIG.1**

**FIG.2**

FIG.3

FIG.4